# EUROPEAN PATENT APPLICATION

(11) **EP 4 156 264 A1**
(43) Date of publication of application: **29.03.2023**
(21) Application number: 22197250.8
(22) Date of filing: 22.09.2022
(51) Int. Cl.: H01L 25/075, H01L 27/15, H01L 33/06, H01L 33/36, H01L 33/62

(54) **DISPLAY DEVICE**

(30) Priority: 23.09.2021 KR 20210125864
(71) Applicant: Samsung Display Co., Ltd., Yongin-si, Gyeonggi-do 17113 (KR)
(72) Inventor: LEE, Tae Hee, 17113 Yongin-si (KR); LEE, Hyun Wook, 17113 Yongin-si (KR)
(74) Representative: Taor, Simon Edward William

(57) **Abstract**

A display device includes a first electrode and a second electrode, spaced apart from each other; light emitting elements disposed between the first electrode and the second electrode; a first connection electrode electrically contacting the first electrode and first end portions of the light emitting elements; a second connection electrode electrically contacting the second electrode and second end portions of the light emitting elements; and a conductive pattern disposed between the first connection electrode and the second connection electrode. A first end portion of the conductive pattern electrically contacts the first connection electrode, and a second end portion of the conductive pattern electrically contacts the second connection electrode.

## Description

### CROSS-REFERENCE TO RELATED APPLICATION(S)

The application claims priority to and benefits of Korean patent application 10-2021-0125864, filed on September 23, 2021 in the Korean Intellectual Property Office (KIPO.

### BACKGROUND

### 1. Technical Field

The disclosure generally relates to a display device.

### 2. Description of the Related Art

As interest in information displays is increased, research and development of display devices have been continuously conducted.

### SUMMARY

Embodiments provide a display device capable of reducing a dark spot defect of a pixel.

In accordance with an aspect of the disclosure, there is provided a display device including a first electrode and a second electrode, spaced apart from each other; light emitting elements disposed between the first electrode and the second electrode; a first connection electrode electrically contacting the first electrode and first end portions of the light emitting elements; a second connection electrode electrically contacting the second electrode and second end portions of the light emitting elements; and a conductive pattern disposed between the first connection electrode and the second connection electrode. A first end portion of the conductive pattern electrically contacts the first connection electrode, and a second end portion of the conductive pattern electrically contacts the second connection electrode.

A length of the conductive pattern may be greater than or equal to lengths of the light emitting elements.

The conductive pattern may have a resistance higher than resistances of the light emitting elements.

The conductive pattern may have a resistance of about 100 kΩ or more.

The display device may further include a first insulating layer disposed over the first electrode and the second electrode; and a second insulating layer disposed on the light emitting elements. The second insulating layer may expose the first and second end portions of the light emitting elements.

The conductive pattern may be disposed between the first insulating layer and the second insulating layer.

The second insulating layer may expose the first and second end portions of the conductive pattern.

The first connection electrode may electrically contact the first end portion of the conductive pattern which is exposed by the second insulating layer.

The display device may further include a third insulating layer disposed on the first connection electrode. The third insulating layer may expose the second end portion of the conductive pattern.

The second connection electrode may electrically contact the second end portion of the conductive pattern, which is exposed by the third insulating layer.

In accordance with another aspect of the disclosure, there is provided a display device including first light emitting elements and second light emitting elements, disposed in each pixel; a first connection electrode electrically contacting first end portions of the first light emitting elements; a second connection electrode electrically contacting second end portions of the first light emitting elements and first end portions of the second light emitting elements; a third connection electrode electrically contacting second end portions of the second light emitting elements; a first conductive pattern electrically contacting the first connection electrode and the second connection electrode; and a second conductive pattern electrically contacting the second connection electrode and the third connection electrode.

The first light emitting elements and the second light emitting elements may be electrically connected in series to each other.

The first conductive pattern and the second conductive pattern may include a same material.

The first connection electrode and the third connection electrode may be disposed on a same layer.

The display device may further include third light emitting elements and fourth light emitting elements, disposed in the pixel; a fourth connection electrode electrically contacting second end portions of the third light emitting elements and first end portions of the fourth light emitting elements; and a fifth connection electrode electrically contacting second end portions of the fourth light emitting elements.

The display device may further include a third conductive pattern electrically contacting the third connection electrode and the fourth connection electrode.

The display device may further include a fourth conductive pattern electrically contacting the fourth connection electrode and the fifth connection electrode.

The first to fourth light emitting elements may be electrically connected in series to each other.

The second connection electrode and the fourth connection electrode may be disposed on a same layer.

The fifth connection electrode, the first connection electrode, and the third connection electrode are disposed on a same layer.

According to an aspect, there is provided a display device as set out in claim 1. Additional features are set out in claims 2 to 8. According to an aspect, there is provided a display device as set out in claim 9. Additional features are set out in claims 10 to 15.

### BRIEF DESCRIPTION OF THE DRAWINGS

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will convey the scope of the example embodiments to those skilled in the art.

In the drawing figures, dimensions may be exaggerated for clarity of illustration. It will be understood that when an element is referred to as being "between" two elements, it can be the only element between the two elements, or one or more intervening elements may also be. Like reference numerals refer to like elements throughout.
FIG. 1 is a schematic perspective view illustrating a light emitting element in accordance with an embodiment of the disclosure.
FIG. 2 is a schematic cross-sectional view illustrating the light emitting element in accordance with the embodiment of the disclosure.
FIG. 3 is a schematic plan view illustrating a display device in accordance with an embodiment of the disclosure.
FIG. 4 is a schematic diagram of equivale circuit of a pixel in accordance with an embodiment of the disclosure.
FIGS. 5 and 6 are schematic plan views illustrating a pixel in accordance with an embodiment of the disclosure.
FIG. 7 is a schematic cross-sectional view taken along line A-A' shown in FIG. 5.
FIG. 8 is a schematic enlarged cross-sectional view of area B shown in FIG. 7.
FIG. 9 is a schematic cross-sectional view taken along line C-C' shown in FIG. 5.
FIG. 10 is a schematic cross-sectional view illustrating first to third pixels in accordance with an embodiment of the disclosure.

### DETAILED DESCRIPTION OF THE EMBODIMENTS

The effects and characteristics of the disclosure and a method of achieving the effects and characteristics will be clear by referring to the embodiments described below in detail together with the accompanying drawings. However, the disclosure is not limited to the embodiments disclosed herein but may be implemented in various forms. The embodiments are provided by way of example only so that a person of ordinary skilled in the art can fully understand the features in the disclosure and the scope thereof.

The terminology used herein is for the purpose of describing particular embodiments only and is not construed as limiting the disclosure. As used herein, the singular forms are intended to include the plural forms (or meanings) as well, unless the context clearly indicates otherwise. The terms "comprises/includes" and/or "comprising/including," when used in this specification, specify the presence of mentioned component, step, operation and/or element, but do not exclude the presence or addition of one or more other components, steps, operations and/or elements.

When described as that any element is "connected", "coupled" or "accessed" to another element, it should be understood that it is possible that still another element may "connected", "coupled" or "accessed" between the two elements as well as that the two elements are directly "connected", "coupled" or "accessed" to each other.

The term "on" that is used to designate that an element or layer is on another element or layer includes both a case where an element or layer is located directly on another element or layer, and a case where an element or layer is located on another element or layer via still another element layer. Like reference numerals generally denote like elements throughout the specification.

It will be understood that, although the terms "first," "second," and the like may be used herein to describe various elements, these elements should not be limited by these terms. These terms are only used to distinguish one element from another element. Thus, a "first" element discussed below could also be termed a "second" element without departing from the teachings of the disclosure.

The terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

It will be understood that the terms "contact," "connected to," and "coupled to" may include a physical and/or electrical contact, connection, or coupling.

The phrase "at least one of" is intended to include the meaning of "at least one selected from the group of" for the purpose of its meaning and interpretation. For example, "at least one of A and B" may be understood to mean "A, B, or A and B."

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Hereinafter, embodiments of the disclosure will be described in more detail with reference to the accompanying drawings.

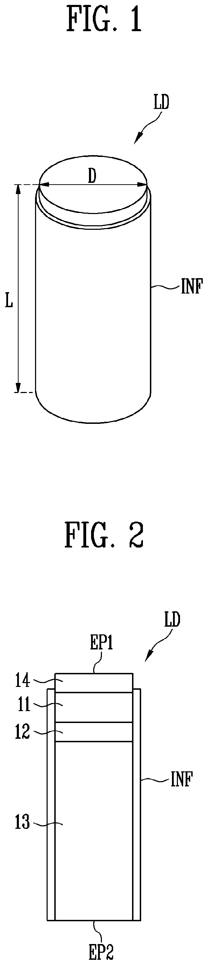

FIG. 1 is a schematic perspective view illustrating a light emitting element in accordance with an embodiment. FIG. 2 is a schematic cross-sectional view illustrating the light emitting element in accordance with an embodiment. Although FIGS. 1 and 2 illustrate a pillar-shaped light emitting element LD, the kind and/or shape of the light emitting element LD of embodiments is not limited thereto.

Referring to FIGS. 1 and 2, the light emitting element LD may include a first semiconductor layer 11, an active layer 12, a second semiconductor layer 13, and/or an electrode layer 14.

The light emitting element LD may be provided in a pillar shape extending in a direction. The light emitting element LD may have a first end portion EP1 and a second end portion EP2. One of the first and second semiconductor layers 11 and 13 may be disposed at the first end portion EP1 of the light emitting element LD. The other of the first and second semiconductor layers 11 and 13 may be disposed at the second end portion EP2 of the light emitting element LD. For example, the first semiconductor layer 11 may be disposed at the first end portion EP1 of the light emitting element LD, and the second semiconductor layer 13 may be disposed at the second end portion EP2 of the light emitting element LD.

In some embodiments, the light emitting element LD may be a light emitting element manufactured in a pillar shape by an etching process, etc. In this specification, the term "pillar shape" may include a rod-like shape or bar-like shape, of which an aspect ratio is greater than 1, such as a cylinder or a polyprism, and the shape of its section is not particularly limited.

The light emitting element LD may have a small size to a degree of nanometer scale to micrometer scale. In an example, the light emitting element LD may have a diameter D (or width) in a range of nanometer scale to micrometer scale and/or a length L in a range of nanometer scale to micrometer scale. However, the size of the light emitting element LD of embodiments is not limited thereto, and the size of the light emitting element LD may be variously changed according to design conditions of various types of devices, e.g., a display device, and the like, which use, as a light source, a light emitting device using the light emitting element LD.

The first semiconductor layer 11 may be a first conductivity type semiconductor layer. For example, the first semiconductor layer 11 may include a p-type semiconductor layer. In an example, the first semiconductor layer 11 may include at least one semiconductor material among InAIGaN, GaN, AIGaN, InGaN, AIN, and InN, and include a p-type semiconductor layer doped with a first conductivity type dopant such as Mg. However, the material forming (or constituting) the first semiconductor layer 11 of embodiments is not limited thereto. In addition, the first semiconductor layer 11 may be configured with various materials.

The active layer 12 may be disposed between the first semiconductor layer 11 and the second semiconductor layer 13. The active layer 12 may include a structure among a single well structure, a multi-well structure, a single quantum well structure, a multi-quantum well (MQW) structure, a quantum dot structure, and a quantum wire structure, but embodiments of the disclosure are not limited thereto. The active layer 12 may include GaN, InGaN, InAIGaN, AIGaN, AIN, or the like. In addition, the active layer 12 may be configured with various materials.

In case that a voltage which is a threshold voltage or more is applied to both ends of the light emitting element LD, the light emitting element LD emits light as electron-hole pairs are combined in the active layer 12. The light emission of the light emitting element LD is controlled by using such a principle, so that the light emitting element LD can be used as a light source for various light emitting devices, including a pixel of a display device.

The second semiconductor layer 13 is formed on the active layer 12 and may include a semiconductor layer having a type different from that of the first semiconductor layer 11. For example, the second semiconductor layer 13 may include an n-type semiconductor layer. In an example, the second semiconductor layer 13 may include any semiconductor material among InAIGaN, GaN, AIGaN, InGaN, AIN, and InN, and include an n-type semiconductor layer doped with a second conductivity type dopant such as Si, Ge, or Sn. However, the material forming the second semiconductor layer 13 of embodiments is not limited thereto. In addition, the second semiconductor layer 13 may be configured with various materials.

The electrode layer 14 may be disposed on the first end portion EP1 and/or the second end portion EP2 of the light emitting element LD. Although FIG. 2 illustrates, as an example, that the electrode layer 14 is formed on the first semiconductor layer 11, embodiments of the disclosure are not limited thereto. For example, a separate electrode layer may be further disposed on the second semiconductor layer 13.

The electrode layer 14 may include a transparent metal or a transparent metal oxide. In an example, the electrode layer 14 may include at least one of indium tin oxide (ITO), indium zinc oxide (IZO), zinc oxide (ZnO), and zinc tin oxide (ZTO), but embodiments of the disclosure are not limited thereto. In case that the electrode layer 14 may be made of (or include) a transparent metal or a transparent metal oxide, light generated in the active layer 12 of the light emitting element LD may pass through the electrode layer 14 and then be emitted to the outside of the light emitting element LD.

An insulative film INF may be provided on a surface of the light emitting element LD. The insulative film INF may be disposed directly on surfaces of the first semiconductor layer 11, the active layer 12, the second semiconductor layer 13, and/or the electrode layer 14. The insulative film INF may expose the first and second end portions EP1 and EP2 of the light emitting element LD, which have different polarities. In some embodiments, the insulative film INF may expose a side portion of the electrode layer 14 and/or the second semiconductor layer 13 adjacent to the first and second end portions EP1 and EP2 of the light emitting element LD.

The insulative film INF may prevent an electrical short circuit which may occur in case that the active layer 12 contacts (or is in contact with) a conductive material except the first and second semiconductor layers 11 and 13. Also, the insulative film INF may minimize a surface defect of light emitting elements LD, thereby the lifespan and light emission efficiency of the light emitting elements LD.

The insulative film INF may include at least one of silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ). For example, the insulative film INF may be configured as a double layer, and layers forming the double layer may include different materials. In an example, the insulative film INF may be configured as a double layer including aluminum oxide (AlOₓ) and silicon oxide (SiOₓ), but embodiments of the disclosure are not limited thereto. In some embodiments, the insulative film INF may be omitted.

A light emitting device including the above-described light emitting element LD may be used in various kinds of devices which require a light source, including a display device. For example, light emitting elements LD may be disposed in each pixel of a display panel and be used as a light source of each pixel. However, the application field of the light emitting element LD of embodiments is not limited to the above-described example. For example, the light emitting element LD may be used in other types of devices that require a light source, such as a lighting device.

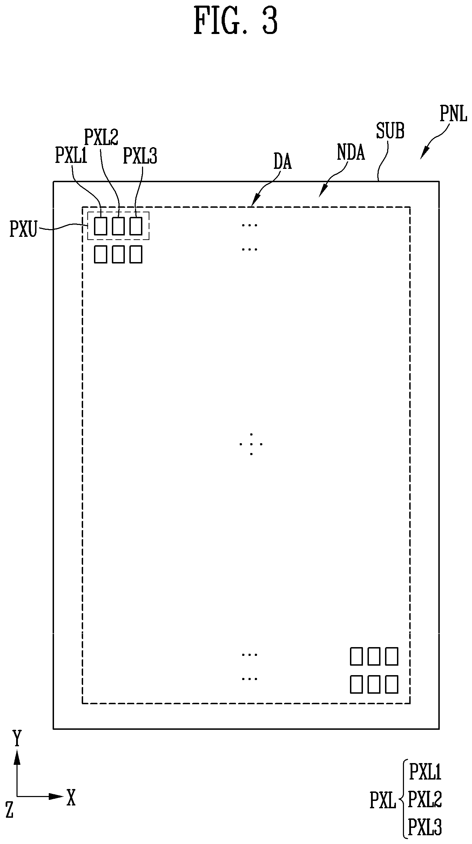

FIG. 3 is a schematic plan view illustrating a display device in accordance with an embodiment.

FIG. 3 illustrates a display device, particularly, a display panel PNL provided in the display device as an example of an electronic device which can use, as a light source, the light emitting element LD described in the embodiment shown in FIGS. 1 and 2.

For convenience of description, FIG. 3 illustrates a structure of the display panel PNL, focusing on a display area DA. However, in some embodiments, at least one driving circuit (e.g., at least one of a scan driver and a data driver), lines, and/or pads, which are not shown in the drawing, may be further disposed in the display panel PNL.

Referring to FIG. 3, the display panel PNL and a substrate SUB for forming the same may include the display area DA for displaying an image and a non-display area NDA except the display area DA. The display area DA may constitute a screen on which the image is displayed, and the non-display area NDA may be the other area excluding the display area DA.

A pixel part PXU may be disposed in the display area DA. The pixel part PXU may include a first pixel PXL1, a second pixel PXL2, and/or a third pixel PXL3. Hereinafter, in case that at least one pixel among the first pixel PXL1, the second pixel PXL2, and the third pixel PXL3 is arbitrarily designated or in case that two or more kinds of pixels among the first pixel PXL1, the second pixel PXL2, and the third pixel PXL3 are inclusively designated, the corresponding pixel or the corresponding pixels will be referred to as a "pixel PXL" or "pixels PXL."

The pixels PXL may be regularly arranged according to a stripe structure, a PENTILE^{™} structure, or the like. However, the arrangement structure of the pixels PXL of embodiments is not limited thereto, and the pixels PXL may be arranged in the display area DA by using various structures and/or methods.

In some embodiments, two or more kinds of pixels PXL emitting lights of different colors may be disposed in the display area DA. In an example, first pixels PXL1 emitting light of a first color, second pixels PXL2 emitting light of a second color, and third pixels PXL3 emitting light of a third color may be arranged in the display area DA. At least one first pixel PXL1, at least one second pixel PXL2, and at least one third pixel PXL3, which are disposed adjacent to each other, may form a pixel part (or pixel unit) PXU capable of emitting light of various colors. For example, each of the first to third pixels PXL1, PXL2, and PXL3 may be a pixel emitting light of a color. In some embodiments, the first pixel PXL1 may be a red pixel emitting light of red, the second pixel PXL2 may be a green pixel emitting light of green, and the third pixel PXL3 may be a blue pixel emitting light of blue. However, embodiments of the disclosure are not limited thereto.

In an embodiment, the first pixel PXL1, the second pixel PXL2, and the third pixel PXL3 have light emitting elements emitting light of a same color, and may include color conversion layers and/or color filters of different colors, which are disposed on the respective light emitting elements, to respectively emit light of the first color, light of the second color, and light of the third color. In another embodiment, the first pixel PXL1, the second pixel PXL2, and the third pixel PXL3 respectively have, as light sources, a light emitting element of the first color, a light emitting element of the second color, and a light emitting element of the third color, so that the light emitting elements can respectively emit light of the first color, light of the second color, and light of the third color. However, the color, kind, and/or number of pixels PXL forming each pixel part PXU is not particularly limited in embodiments. In an example, the color of light emitted by each pixel PXL may be variously changed.

The pixel PXL may include at least one light source driven by a control signal (e.g., a scan signal and a data signal) and/or a power source (e.g., a first power source and a second power source). In an embodiment, the light source may include at least one light emitting element LD in accordance with the embodiment shown in FIGS. 1 and 2, e.g., a subminiature pillar-shaped light emitting element LD having a small size to a degree of nanometer scale to micrometer scale. However, the disclosure is not limited thereto. In addition, various types of light emitting elements LD may be used as the light source of the pixel PXL.

In an embodiment, each pixel PXL may be configured as an active pixel. However, the kind, structure, and/or driving method of pixels PXL which can be applied to the display device is not particularly limited. For example, each pixel PXL may be configured as a pixel of a passive or active light emitting display device using various structures and/or driving methods.

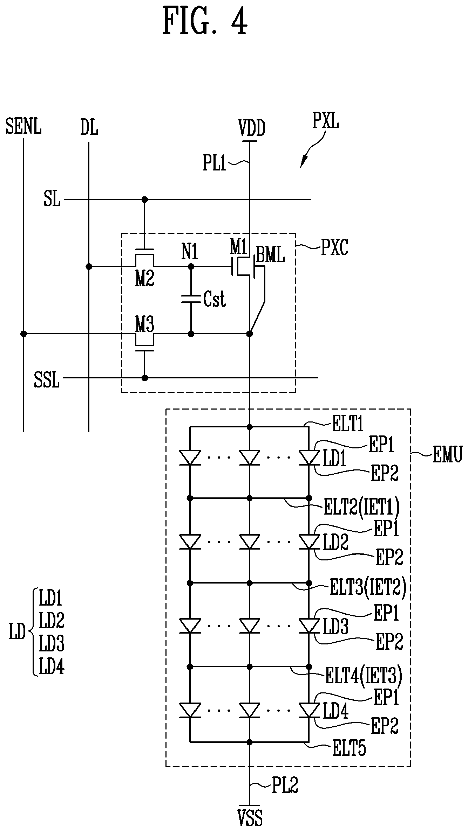

FIG. 4 is a schematic diagram of an equivalent circuit of a pixel in accordance with an embodiment.

In some embodiments, the pixel PXL shown in FIG. 4 may be one of the first pixel PXL1, the second pixel PXL2, and the third pixel PXL3, which are provided in the display panel PNL shown in FIG. 3. The first pixel PXL1, the second pixel PXL2, and the third pixel PXL3 may have a substantially identical or similar structure.

Referring to FIG. 4, the pixel PXL may include a light emitting part EMU for generating light with a luminance corresponding to a data signal and a pixel circuit PXC for driving the light emitting part EMU.

The pixel circuit PXC may be electrically connected between a first power source VDD and the light emitting part (or light emitting unit) EMU. Also, the pixel circuit PXC may be electrically connected to a scan line SL and a data line DL of the corresponding pixel PXL to control an operation of the light emitting part EMU, in response to a scan signal and the data signal, which are supplied from the scan line SL and the data line DL, respectively. Also, the pixel circuit PXC may be selectively further electrically connected to a sensing signal line SSL and a sensing line SENL.

The pixel circuit PXC may include at least one transistor and a capacitor. For example, the pixel circuit PXC may include a first transistor M1, a second transistor M2, a third transistor M3, and a storage capacitor Cst.

The first transistor M1 may be electrically connected between the first power source VDD and a first connection electrode ELT1. A gate electrode of the first transistor M1 is electrically connected to a first node N1. The first transistor M1 may control a driving current supplied to the light emitting part EMU, in response to a voltage of the first node N1. For example, the first transistor M1 may be a driving transistor for controlling the driving current of the pixel PXL.

In an embodiment, the first transistor M1 may selectively include a lower conductive layer BML (also referred to as a "lower electrode," a "back gate electrode," or a "lower light blocking layer"). The gate electrode and the lower conductive layer BML of the first transistor M1 may overlap (e.g., in a plan view) each other with an insulating layer interposed therebetween. In an embodiment, the lower conductive layer BML may be electrically connected to an electrode, e.g., a source or drain electrode of the first transistor M1.

In case that the first transistor M1 includes the lower conductive layer BML, there may be applied a back-biasing technique (or sync technique) for moving a threshold voltage of the first transistor M1 in a negative direction or positive direction by applying a back-biasing voltage to the lower conductive layer BML of the first transistor M1 in driving of the pixel PXL. In an example, a source-sync technique is applied by electrically connecting the lower conductive layer BML to a source electrode of the first transistor M1, so that the threshold voltage of the first transistor M1 can be moved in the negative direction or positive direction. In addition, in case that the lower conductive layer BML is disposed on the bottom of a semiconductor pattern forming a channel of the first transistor M1, the lower conductive layer BML severs as a light blocking pattern, thereby stabilizing operational characteristics of the first transistor M1. However, the function and/or application method of the lower conductive layer BML of embodiments is not limited thereto.

The second transistor M2 may be electrically connected between the data line DL and the first node N1. In addition, a gate electrode of the second transistor M2 is electrically connected to the scan line SL. The second transistor M2 is turned on in case that a scan signal having a gate-on voltage (e.g., a high-level voltage) is supplied from the scan line SL, to electrically connect the data line DL and the first node N1 to each other.

A data signal of a corresponding frame may be supplied to the data line DL for each frame period. The data signal may be transmitted to the first node N1 through the turned-on second transistor M2 during a period in which the scan signal having the gate-on voltage is supplied. For example, the second transistor M2 may be a switching transistor for transmitting each data signal to the inside of the pixel PXL.

One electrode (or first electrode) of the storage capacitor Cst may be electrically connected to the first node N1, and the other electrode (or second electrode) of the storage capacitor Cst may be electrically connected to a second electrode of the first transistor M1. The storage capacitor Cst is charged with a voltage corresponding to the data signal supplied to the first node N1 during each frame period.

The third transistor M3 may be electrically connected between the first connection electrode ELT1 (or the second electrode of the first transistor M1) and the sensing line SENL. In addition, a gate electrode of the third transistor M3 may be electrically connected to the sensing signal line SSL. The third transistor M3 may transmit a voltage applied to the first connection electrode ELT1 to the sensing line SENL according to a sensing signal supplied to the sensing signal line SSL. The voltage transmitted through the sensing line SENL may be provided to an external circuit (e.g., a timing controller), and the external circuit may extract characteristic information (e.g., the threshold voltage of the first transistor M1), based on the provided voltage. The extracted characteristic information may be used to convert image data such that a characteristic deviation between the pixels PXL is compensated.

Meanwhile, although FIG. 4 illustrates that the transistors included in the pixel circuit PXC are provided as an n-type transistor, embodiments of the disclosure are not limited thereto. For example, at least one of the first, second, and third transistors M1, M2, and M3 may be changed to a p-type transistor.

In addition, the structure and driving method of the pixel PXL may be variously changed in some embodiments. For example, the pixel circuit PXC may be configured as a pixel circuit having various structures and/or various driving methods, in addition to the embodiment shown in FIG. 4.

In an example, the pixel circuit PXC may not include the third transistor M3. Also, the pixel circuit PXC may further include other circuit elements such as a compensation transistor for compensating for the threshold voltage of the first transistor M1, etc., an initialization transistor for initializing a voltage of the first node N1 and/or the first connection electrode ELT1, an emission control transistor for controlling a period in which a driving current is supplied to the light emitting part EMU, and/or a boosting capacitor for boosting the voltage of the first node N1.

The light emitting part EMU may include at least one light emitting element LD, e.g., light emitting elements LD electrically connected between the first power source VDD and a second power source VSS.

For example, the light emitting part EMU may include the first connection electrode ELT1 electrically connected to the first power source VDD through the pixel circuit PXC and a first power line PL1, a fifth connection electrode ELT5 electrically connected to the second power source VSS through a second power line PL2, and light emitting elements LD electrically connected between the first and fifth connection electrodes ELT1 and ELT5.

The first power source VDD and the second power source VSS may have different potentials such that the light emitting elements LD can emit light. In an example, the first power source VDD may be set as a high-potential power source, and the second power source VSS may be set as a low-potential power source.

In an embodiment, the light emitting part EMU may include at least one serial stage. Each serial stage may include a pair of electrodes (e.g., two electrodes) and one or more light emitting elements LD electrically connected in a forward direction between the pair of electrodes. The number of serial stages forming the light emitting part EMU and the number of light emitting elements LD forming each serial stage are not particularly limited. In an example, the numbers of light emitting elements LD forming the respective serial stages may be equal to or different from each other, and a number of light emitting elements LD is not particularly limited.

For example, the light emitting part EMU may include a first serial stage including at least one first light emitting element LD1, a second serial stage including at least one second light emitting element LD2, a third serial stage including at least one third light emitting element LD3, and a fourth serial stage including at least one fourth light emitting element LD4.

The first serial stage may include the first connection electrode ELT1, a second connection electrode ELT2, and at least one first light emitting element LD1 electrically connected between the first and second connection electrodes ELT1 and ELT2. Each first light emitting element LD1 may be electrically connected in the forward direction between the first and second connection electrodes ELT1 and EL2. For example, a first end portion EP1 of the first light emitting element LD1 may be electrically connected to the first connection electrode ELT1, and a second end portion EP2 of the first light emitting element LD1 may be electrically connected to the second connection electrode ELT2.

The second serial stage may include the second connection electrode ELT2 and a third connection electrode ELT3, and at least one second light emitting elements LD2 electrically connected between the second and third connection electrodes ELT2 and ELT3. The respective second light emitting elements LD2 may be electrically connected in the forward direction between the second and third connection electrodes ELT2 and ELT3. For example, a first end portion EP1 of the second light emitting element LD2 may be electrically connected to the second connection electrode ELT2, and a second end portion EP2 of the second light emitting element LD2 may be electrically connected to the third connection electrode ELT3.

The third serial stage may include the third connection electrode ELT3 and a fourth connection electrode ELT4, and at least one third light emitting elements LD3 electrically connected between the third and fourth connection electrodes ELT3 and ELT4. The respective third light emitting elements LD3 may be electrically connected in the forward direction between the third and fourth connection electrodes ELT3 and ELT4. For example, a first end portion EP1 of the third light emitting element LD3 may be electrically connected to the third connection electrode ELT3, and a second end portion EP2 of the third light emitting element LD3 may be electrically connected to the fourth connection electrode ELT4.

The fourth serial stage may include the fourth connection electrode ELT4 and the fifth connection electrode ELT5, and at least one fourth light emitting elements LD4 electrically connected between the fourth and fifth connection electrodes ELT4 and ELT5. Each fourth light emitting element LD4 may be electrically connected in the forward direction between the fourth and fifth connection electrodes ELT4 and ELT5. For example, a first end portion EP1 of the fourth light emitting element LD4 may be electrically connected to the fourth connection electrode ELT4, and a second end portion EP2 of the fourth light emitting element LD4 may be electrically connected to the fifth connection electrode ELT5.

A first electrode, e.g., the first connection electrode ELT1, of the light emitting part EMU may be an anode electrode of the light emitting part EMU. A last electrode, e.g., the fifth connection electrode ELT5, of the light emitting part EMU may be a cathode electrode of the light emitting part EMU.

The other electrodes, e.g., the second connection electrode ELT2, the third connection electrode ELT3, and/or the fourth connection electrode ELT4, of the light emitting part EMU may form respective intermediate electrodes. For example, the second connection electrode ELT2 may form a first intermediate electrode IET1, the third connection electrode ELT3 may form a second intermediate electrode IET2, and the fourth connection electrode ELT4 may form a third intermediate electrode IET3.

In case that light emitting elements LD are electrically connected in a series-parallel structure, power efficiency can be improved as compared with when equal numbers of light emitting elements LD are electrically connected to each other only in parallel. In addition, in the pixel in which the light emitting elements LD are electrically connected to each other in the series-parallel structure, although a short circuit occurs in some serial stages, a luminance can be expressed by light emitting elements LD of other serial stage(s). Hence, the probability that a dark spot defect will occur in the pixel PXL can be reduced. However, embodiments of the disclosure are not limited thereto, and the light emitting part EMU may be configured by electrically connecting the light emitting elements LD to each other only in series or by electrically connecting the light emitting elements LD to each other only in parallel.

Each of the light emitting element LD may include a first end portion EP1 (e.g., a p-type end portion) electrically connected to the first power source VDD via at least one electrode (e.g., the first connection electrode ELT1), the pixel circuit PXC, and/or the first power line PL1, and a second end portion EP2 (e.g., an n-type end portion) electrically connected to the second power source VSS via at least another electrode (e.g., the fifth connection electrode ELT5) and the second power line PL2. For example, the light emitting elements LD may be electrically connected to each other in the forward direction between the first power source VDD and the second power source VSS. The light emitting elements LD electrically connected to each other in the forward direction may form effective light sources of the light emitting part EMU.

In case that a driving current is supplied through the corresponding pixel circuit PXC, the light emitting elements LD may emit light with a luminance corresponding to the driving current. For example, during each frame period, the pixel circuit PXC may supply, to the light emitting part EMU, a driving current corresponding to a grayscale value to be expressed in a corresponding frame. Accordingly, while the light emitting elements LD emit light with the luminance corresponding to the driving current, the light emitting part EMU can express the luminance corresponding to the driving current.

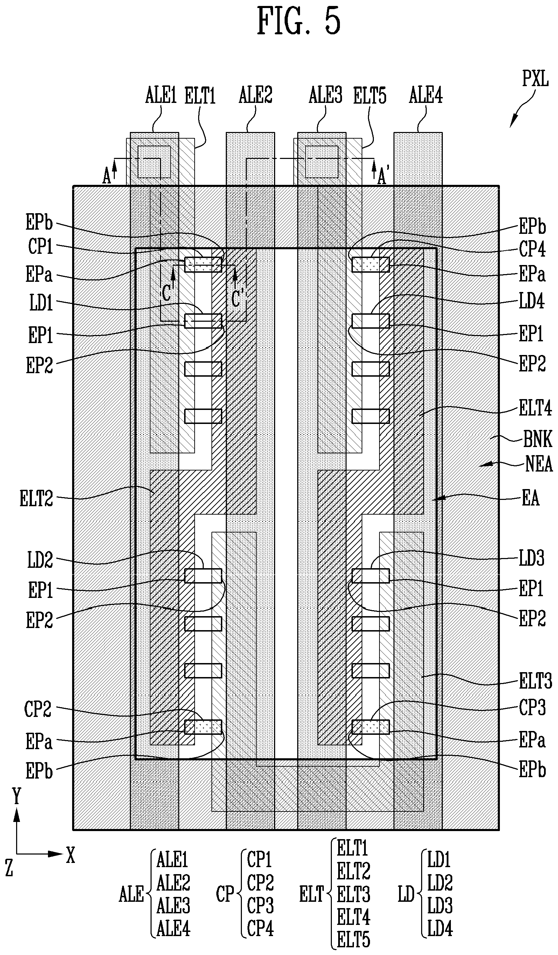

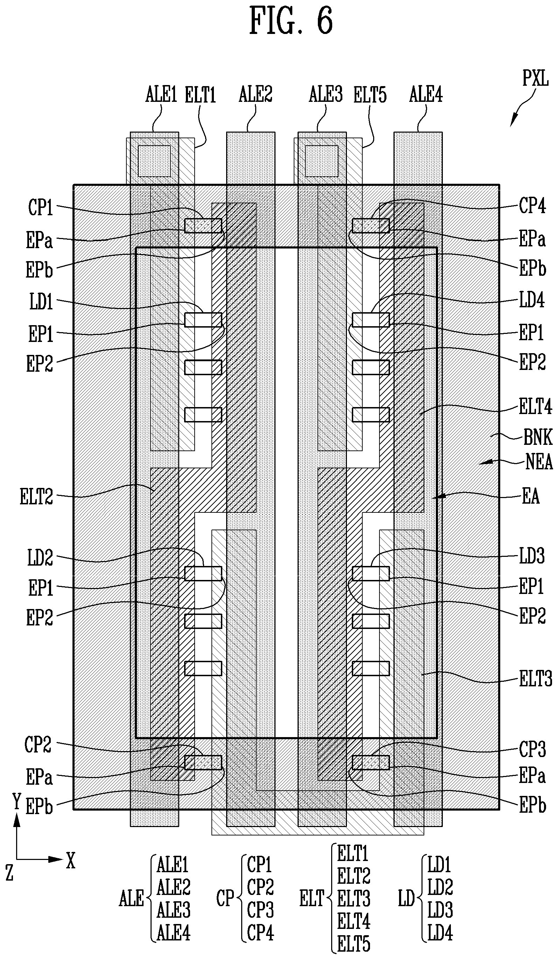

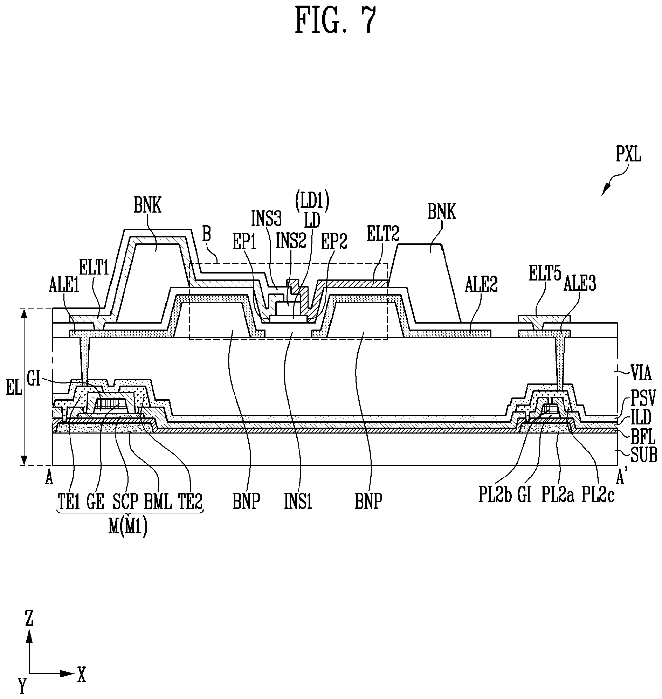

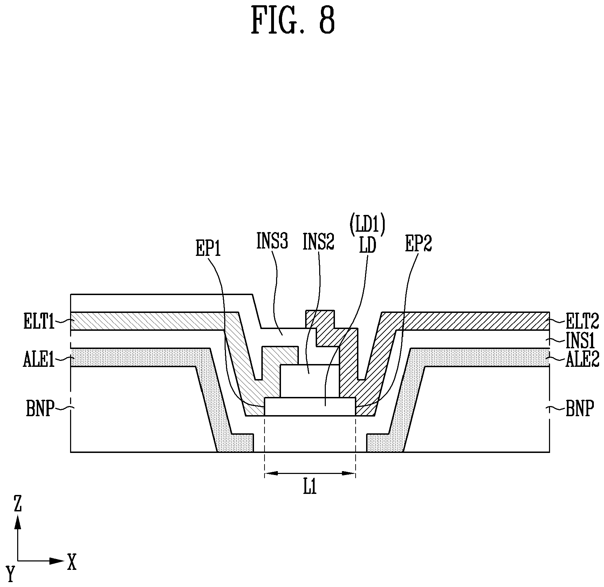

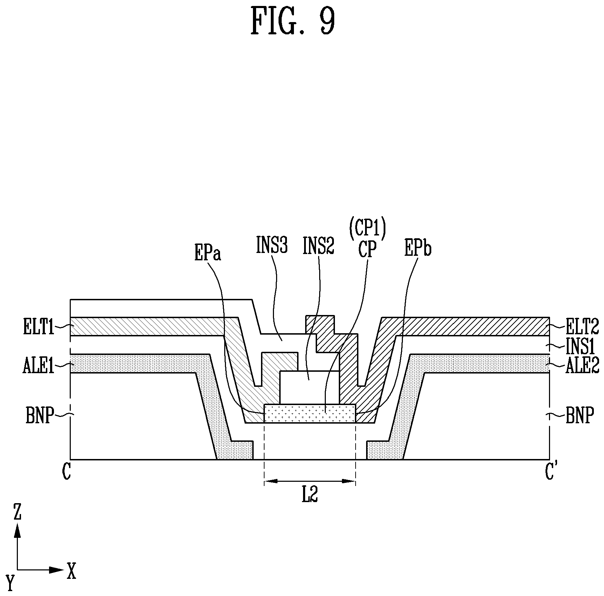

FIGS. 5 and 6 are schematic plan views illustrating a pixel in accordance with an embodiment. FIG. 7 is a schematic cross-sectional view taken along line A-A' shown in FIG. 5. FIG. 8 is a schematic enlarged cross-sectional view of area B shown in FIG. 7. FIG. 9 is a schematic cross-sectional view taken along line C-C' shown in FIG. 5.

In an example, the pixel PXL shown in FIGS. 5 and 6 may be any one of the first to third pixels PXL1, PXL2, and PXL3 forming the pixel part PXU shown in FIG. 3, and the first to third pixels PXL1, PXL2, and PXL3 may have a substantially identical or similar structure. In addition, although FIGS. 5 and 6 illustrate an embodiment in which each pixel PXL includes light emitting elements LD disposed in four serial stages as shown in FIG. 4, the number of serial stages of each pixel PXL may be variously changed in some embodiments.

Hereinafter, in case that at least one of first to fourth light emitting elements LD1, LD2, LD3, and LD4 is arbitrarily designated or in case that two or more kinds of light emitting elements are inclusively designated, the corresponding light emitting element or the corresponding light emitting elements will be referred to as a "light emitting element LD" or "light emitting elements LD." In addition, in case that at least one electrode among electrodes including first to fourth electrodes ALE1, ALE2, ALE3, and ALE4 is arbitrarily designated or in case that two or more kinds of electrodes are inclusively designated, the corresponding electrode or the corresponding electrodes will be referred to as an "electrode ALE" or "electrodes ALE." In case that at least one connection electrode among connection electrodes including first to fifth connection electrodes ELT1, ELT2, ELT3, ELT4, and ELT5 is arbitrarily designated or in case that two or more kinds of connection electrodes are inclusively designated, the corresponding connection electrode or the corresponding connection electrodes will be referred to as a "connection electrode ELT" or "connection electrodes ELT."

Referring to FIGS. 5 and 6, each pixel PXL may include an emission area EA and a non-emission area NEA. The emission area EA may be an area including light emitting elements LD to emit light. The non-emission area NEA may be disposed to surround the emission area EA. The non-emission area NEA may be an area in which a bank BNK surrounding the emission area EA is provided.

Each pixel PXL may include electrodes ALE, light emitting elements LD, connection electrodes ELT, and/or conductive patterns CP. The electrodes ALE may be provided in at least the emission area EA. The electrodes ALE may extend in a second direction (e.g., Y-axis direction) and be spaced from each other in a first direction (e.g., X-axis direction). The electrodes ALE may extend from the emission area EA to the non-emission area NEA. For example, each of the first to fourth electrodes ALE1, ALE2, ALE3, and ALE4 may extend in the second direction (e.g., Y-axis direction) and be spaced apart from each other in the first direction (e.g., X-axis direction) to be sequentially disposed.

Some of the electrodes ALE may be electrically connected to the pixel circuit PXC (see FIG. 4) and/or a power line through contact holes. For example, the first electrode ALE1 may be electrically connected to the pixel circuit PXC and/or the first power line PL1 through a contact hole, and the third electrode ALE3 may be electrically connected to the second power line PL2 through a contact hole.

In some embodiments, some of the electrodes ALE may be electrically connected to some of the connection electrodes ELT through contact holes. For example, the first electrode ALE1 may be electrically connected to the first connection electrode ELT1 through a contact hole, and the third electrode ALE3 may be electrically connected to the fifth connection electrode ELT5 through a contact hole.

A pair of electrodes ALE adjacent to each other may be supplied with different signals in a process of aligning the light emitting elements LD. For example, in case that the first to fourth electrodes ALE1, ALE2, ALE3, and ALE4 are sequentially arranged in the first direction (e.g., X-axis direction) in the emission area EA, the first and second electrodes ALE1 and ALE2 may form a pair and be supplied with different alignment signals, and the third and fourth electrodes ALE3 and ALE4 may form a pair and be supplied with different alignment signals.

In an embodiment, the second and third electrodes ALE2 and ALE3 may be supplied with a same signal in the process of aligning the light emitting elements LD. Although FIGS. 5 and 6 illustrate that the second and third electrodes ALE2 and ALE3 are separated from each other, the second and third electrodes ALE2 and ALE3 may be integrally or non-integrally electrically connected to each other in the process of aligning the light emitting elements LD.

In some embodiments, bank patterns BNP (see FIG. 7) may be disposed on the bottom of the electrodes ALE. The bank patterns BNP may be provided in at least the emission area EA. The bank patterns BNP may extend in the second direction (e.g., Y-axis direction) and be spaced apart from each other in the first direction (e.g., X-axis direction).

In case that each of the bank patterns BNP is provided on the bottom of an area of each of the electrodes ALE, the area of each of the electrodes ALE may protrude in an upward direction of the pixel PXL, for example, a third direction (e.g., Z-axis direction) in an area in which each of the bank patterns BNP is formed. In case that the bank patterns BNP and/or the electrodes ALE include a reflective material, a reflective wall structure may be formed at the periphery of the light emitting elements LD. Accordingly, light emitted from the light emitting elements LD can be emitted in the upward direction of the pixel PXL (e.g., a front direction of the display panel PNL, including a viewing angle range (e.g., a predetermined or selected viewing angle range), and thus the light emission efficiency of the display panel PNL can be improved.

Each of the light emitting elements LD may be aligned between a pair of electrodes ALE in the emission area EA. Also, each of the light emitting elements LD may be electrically connected between a pair of connection electrodes ELT.

A first light emitting element LD1 may be aligned between the first and second electrodes ALE1 and ALE2. The first light emitting element LD1 may be electrically connected between the first and second connection electrodes ELT1 and ELT2. In an example, the first light emitting element LD1 may be aligned in a first area (e.g., an upper end area) of the first and second electrodes ALE1 and ALE2. A first end portion EP1 of the first light emitting element LD1 may be electrically connected to the first connection electrode ELT1, and a second end portion EP2 of the first light emitting element LD1 may be electrically connected to the second connection electrode ELT2.

A second light emitting element LD2 may be aligned between the first and second electrodes ALE1 and ALE2. The second light emitting element LD2 may be electrically connected between the second and third connection electrodes ELT2 and ELT3. In an example, the second light emitting element LD2 may be aligned in a second area (e.g., a lower end area) of the first and second electrodes ALE1 and ALE2. A first end portion EP1 of the second light emitting element LD2 may be electrically connected to the second connection electrode ELT2, and a second end portion EP2 of the second light emitting element LD2 may be electrically connected to the third connection electrode ELT3.

A third light emitting element LD3 may be aligned between the third and fourth electrodes ALE3 and ALE4. The third light emitting element LD3 may be electrically connected between the third and fourth connection electrodes ELT3 and ELT4. In an example, the third light emitting element LD3 may be aligned in a second area (e.g., a lower end area) of the third and fourth electrodes ALE3 and ALE4. A first end portion EP1 of the third light emitting element LD3 may be electrically connected to the third connection electrode ELT3, and a second end portion EP2 of the third light emitting element LD3 may be electrically connected to the fourth connection electrode ELT4.

A fourth light emitting element LD4 may be aligned between the third and fourth electrodes ALE3 and ALE4. The fourth light emitting element LD4 may be electrically connected between the fourth and fifth connection electrodes ELT4 and ELT5. In an example, the fourth light emitting element LD4 may be aligned in a first area (e.g., an upper end area) of the third and fourth electrodes ALE3 and ALE4. A first end portion EP1 of the fourth light emitting element LD4 may be electrically connected to the fourth connection electrode ELT4, and a second end portion EP2 of the fourth light emitting element LD4 may be electrically connected to the fifth connection electrode ELT5.

In an example, the first light emitting element LD1 may be located in a left upper end area of the emission area EA, and the second light emitting element LD2 may be located in a left lower end area of the emission area EA. The third light emitting elements LD3 may be located in a right lower end area of the emission area EA, and the fourth light emitting element LD4 may be located in a right upper end area of the emission area EA. However, the arrangement and/or connection structure of the light emitting elements LD may be variously changed according to the structure of the light emitting part EMU and/or the number of serial stages.

Each of the connection electrodes ELT may be provided in at least the emission area EA and be disposed to overlap at least one electrode ALE and/or at least one light emitting element LD. For example, each of the electrodes ELT may be formed on the electrodes ALE and/or the light emitting elements LD to overlap the electrodes ALE and/or the light emitting elements LD. Therefore, the electrodes ELT may be electrically connected to the light emitting elements LD.

The first connection electrode ELT1 may be disposed on the first area (e.g., the upper end area) of the first electrode ALE1 and the first end portions EP1 of the first light emitting elements LD1 to be electrically connected to the first end portions EP1 of the first light emitting elements LD1.

The second connection electrode ELT2 may be disposed on the first area (e.g., the upper end area) of the second electrode ALE2 and the second end portions EP2 of the first light emitting elements LD1 to be electrically connected to the second end portions EP2 of the first light emitting elements LD1. Also, the second connection electrode ELT2 may be disposed on the second area (e.g., the lower end area) of the first electrode ALE1 and the first end portions EP1 of the second light emitting elements LD2 to be electrically connected to the first end portions EP1 of the second light emitting elements LD2. For example, the second connection electrode ELT2 may electrically connect the second end portions EP2 of the first light emitting elements LD1 and the first end portions EP1 of the second light emitting elements LD2 to each other in the emission area EA. To this end, the second connection electrode ELT2 may have a bent shape. For example, the second connection electrode ELT2 may be bent or curved at a boundary between an area in which at least one first light emitting element LD1 is arranged and an area in which at least one second light emitting element LD2 is arranged.

The third connection electrode ELT3 may be disposed on the second area (e.g., the lower end area) of the second electrode ALE2 and the second end portions EP2 of the second light emitting elements LD2 to be electrically connected to the second end portions EP2 of the second light emitting elements LD2. Also, the third connection electrode ELT3 may be disposed on the second area (e.g., the lower end area) of the fourth electrode ALE4 and the first end portions EP1 of the third light emitting elements LD3 to be electrically connected to the first end portions EP1 of the third light emitting elements LD3. For example, the third connection electrode ELT3 may electrically connect the second end portions EP2 of the second light emitting elements LD2 and the first end portions EP1 of the third light emitting elements LD3 to each other in the emission area EA. To this end, the third connection electrode ELT3 may have a bent shape. For example, the third connection electrode ELT3 may be bent or curved at a boundary between an area in which at least one second light emitting element LD2 is arranged and an area in which at least one third light emitting element LD3 is arranged.

The fourth connection electrode ELT4 may be disposed on the second area (e.g., the lower end area) of the third electrode ALE3 and the second end portions EP2 of the third light emitting elements LD3 to be electrically connected to the second end portions EP2 of the third light emitting elements LD3. Also, the fourth connection electrode ELT4 may be disposed on the first area (e.g., the upper end area) of the fourth electrode ALE4 and the first end portions EP1 of the fourth light emitting elements LD4 to be electrically connected to the first end portions EP1 of the fourth light emitting elements LD4. For example, the fourth connection electrode ELT4 may electrically connect the second end portions EP2 of the third light emitting elements LD3 and the first end portions EP1 of the fourth light emitting elements LD4 to each other in the emission area EA. To this end, the fourth connection electrode ELT4 may have a bent shape. For example, the fourth connection electrode ELT4 may be bent or curved at a boundary between an area in which at least one third light emitting element LD3 is arranged and an area in which at least one fourth light emitting element LD4 is arranged.

The fifth connection electrode ELT5 may be disposed on the first area (e.g., the upper end area) of the third electrode ALE3 and the second end portions EP2 of the fourth light emitting elements LD4 to be electrically connected to the second end portions EP2 of the fourth light emitting elements LD4.

In the above-described manner, the light emitting elements LD aligned between the electrodes ALE may be electrically connected in a desired form by using the connection electrodes ELT. For example, the first light emitting elements LD1, the second light emitting elements LD2, the third light emitting elements LD3, and the fourth light emitting elements LD4 may be sequentially connected in series by using the connection electrodes ELT.

The conductive patterns CP may be disposed between the connection electrodes ELT to contact (or be in contact with) the connection electrode ELT. In an embodiment, the conductive patterns CP are high-resistance patterns and may have a resistance higher than that of the light emitting elements LD. As described above, in case that the high-resistance patterns CP are formed between the connection electrodes ELT, a current can flow even in case that an open defect occurs in some serial stages. Accordingly, a luminance (e.g., a predetermined or selected luminance) can be expressed by light emitting elements LD of the other serial stages, and thus a dark spot defect of the pixel PXL can be reduced.

In an example, in case that the light emitting elements LD have a resistance of about 1 kΩ, the conductive patterns CP may have a resistance of about 10 kΩ or higher. As another example, the conductive patterns CP may have a resistance of about 100 kΩ or higher in consideration of current distribution. However, embodiments of the disclosure are not limited thereto, and the resistance of the conductive patterns CP may be variously changed by considering the resistance of the light emitting elements LD, current distribution, and a loss rate.

The conductive patterns CP may be provided in the emission area EA as shown in FIG. 5. However, embodiments of the disclosure are not limited thereto, and the conductive patterns CP may be provided in the non-emission area NEA as shown in FIG. 6. The conductive patterns CP may be disposed to overlap (e.g., in a plan view) the bank BNK.

A first conductive pattern CP1 may be disposed between the first and second connection electrodes ELT1 and ELT2 to contact the first and second connection electrodes ELT1 and ELT2. In an example, a first end portion EPa of the first conductive pattern CP1 may contact the first connection electrode ELT1, and a second end portion EPb of the first conductive pattern CP1 may contact the second connection electrode ELT2. Also, the first conductive pattern CP1 may be disposed between the first and second electrodes ALE1 and ALE2. In an example, the first conductive pattern CP1 may be disposed in the first area (e.g., the upper end area) of the first and second electrodes ALE1 and ALE2. The first conductive pattern CP1 may be disposed between the first light emitting elements LD1 and the bank BNK in a plan view, but embodiments of the disclosure are not limited thereto.

A second conductive pattern CP2 may be disposed between the second and third connection electrodes ELT2 and ELT3, to contact the second and third connection electrodes ELT2 and ELT3. In an example, a first end portion EPa of the second conductive pattern CP2 may contact the second connection electrode ELT2, and a second end portion EPb of the second conductive pattern CP2 may contact the third connection electrode ELT3. Also, the second conductive pattern CP2 may be disposed between the first and second electrodes ALE1 and ALE2. In an example, the second conductive pattern CP2 may be disposed in the second area (e.g., the lower end area) of the first and second electrodes ALE1 and ALE2. The second conductive pattern CP2 may be disposed between the second light emitting elements LD2 and the bank BNK in a plan view, but embodiments of the disclosure are not limited thereto.

A third conductive pattern CP3 may be disposed between the third and fourth connection electrodes ELT3 and ELT4 to contact the third and fourth connection electrodes ELT3 and ELT4. In an example, a first end portion EPa of the third conductive pattern CP3 may contact the third connection electrode ELT3, and a second end portion EPb of the third conductive pattern CP3 may contact the fourth connection electrode ELT4. Also, the third conductive pattern CP3 may be disposed between the third and fourth electrodes ALE3 and ALE4. In an example, the third conductive pattern CP3 may be disposed in the second area (e.g., the lower end area) of the third and fourth electrodes ALE3 and ALE4. The third conductive pattern CP3 may be disposed between the third light emitting elements LD3 and the bank BNK in a plan view, but embodiments the disclosure are not limited thereto.

A fourth conductive pattern CP4 may be disposed between the fourth and fifth connection electrodes ELT4 and ELT5 to contact the fourth and fifth connection electrodes ELT4 and ELT5. In an example, a first end portion EPa of the fourth conductive pattern CP4 may contact the fourth connection electrode ELT4, and a second end portion EPb of the fourth conductive pattern CP4 may contact the fifth connection electrode ELT5. Also, the fourth conductive pattern CP4 may be disposed between the third and fourth electrodes ALE3 and ALE4. In an example, the fourth conductive pattern CP4 may be disposed in the first area (e.g., the upper end area) of the third and fourth electrodes ALE3 and ALE4. The fourth conductive pattern CP4 may be disposed between the fourth light emitting elements LD4 and the bank BNK in a plan view, but embodiments of the disclosure are not limited thereto.

In an example, the first conductive pattern CP1 may be located in the left upper end area of the emission area EA, and the second conductive pattern CP2 may be located in the left lower end area of the emission area EA. The third conductive pattern CP3 may be located in the right lower end area of the emission area EA, and the fourth conductive pattern CP4 may be located in the right upper end area of the emission area EA. However, the arrangement and/or connection structure of the conductive patterns CP may be variously changed according to the structure of the connection electrodes ELT and/or the number of serial stages.

In an embodiment, the first to fourth conductive patterns CP1, CP2, CP3, and CP4 may include a same material. The first to fourth conductive patterns CP1, CP2, CP3, and CP4 may be simultaneously formed by a same process, but embodiments the disclosure are not limited thereto. In an example, the first to fourth conductive patterns CP1, CP2, CP3, and CP4 may be made of indium gallium zinc oxide (IGZO), indium gallium zinc tin oxide (IGZTO), indium zinc oxide (IZO), gallium zinc tin oxide (GZTO), indium tin zinc oxide (ITZO), amorphous silicon, or the like, but embodiments the disclosure are not limited thereto.

The bank BNK may be provided in the non-emission area NEA to surround the emission area EA. Also, the bank BNK may include an opening exposing the emission area EA of the pixel PXL. The bank BNK may form a dam structure defining the emission area EA to which the light emitting elements LD are to be supplied in a process of supplying the light emitting elements LD. For example, the emission area EA is partitioned by the bank BNK, so that a desired kind and/or amount of light emitting element ink can be supplied to the emission area EA.

The bank BNK may include at least one light blocking material and/or at least one reflective material. Accordingly, light leakage between adjacent pixels PXL can be prevented. For example, the bank BNK may include at least one black matrix material and/or at least one color filter material. In an example, the bank BNK may be formed as a black opaque pattern capable of blocking transmission of light. In an embodiment, a reflective layer (not shown) may be formed on a surface (e.g., a sidewall) of the bank BNK so as to improve the light efficiency of each pixel PXL.

Hereinafter, based on a light emitting element LD and a conductive pattern CP, a sectional structure of each pixel PXL will be described in detail with reference to FIGS. 7 to 9. FIG. 7 illustrates a light emitting element layer EL. FIG. 7 illustrates the first transistor M1 among various circuit elements forming the pixel circuit PXC (see FIG. 4). In case that the first to third transistors M1, M2, and M3 are designated without being distinguished from each other, the first to third transistors M1, M2, and M3 will be inclusively referred to as a "transistor M." The structure of transistors M and/or the positions of the transistors M for each layer is not limited to the embodiment shown in FIG. 7, and may be variously changed in some embodiments.

Referring to FIGS. 7 to 9, the light emitting element layer EL of the pixel PXL in accordance with an embodiment may include circuit elements including transistors M disposed on a substrate SUB and various lines electrically connected thereto. Electrodes ALE, light emitting elements LD, and/or connection electrodes ELT, which form a light emitting part EMU, may be disposed above the circuit elements.

The substrate SUB forms a base member and may be a rigid or flexible substrate or a film. In an example, the substrate SUB may be a rigid substrate made of glass or tempered glass, a flexible substrate (or thin film) made of a plastic or metal material, or at least one insulating layer. The material and/or property of the substrate SUB of embodiments is not particularly limited. In an embodiment, the substrate SUB may be substantially transparent. The term "substantially transparent" may mean that light can be transmitted with a transmittance (e.g., a predetermined or selected transmittance) or more. In another embodiment, the substrate SUB may be translucent or opaque. Also, the substrate SUB may include a reflective material in some embodiments.

A lower conductive layer BML and a first power conductive layer PL2a may be disposed on the substrate SUB. The lower conductive layer BML and the first power conductive layer PL2a may be disposed in a same layer. For example, the lower conductive layer BML and the first power conductive layer PL2a may be simultaneously formed by a same process, but embodiments of the disclosure are not limited thereto. The first power conductive layer PL2a may form the second power line PL2 described with reference to FIG. 4 and the like.

Each of the lower conductive layer BML and the first power conductive layer PL2a may be formed as a single layer or a multi-layer, which is made of at least one of molybdenum (Mo), copper (Cu), aluminum (Al), chromium (Cr), gold (Au), titanium (Ti), nickel (Ni), neodymium (Nd), and indium tin oxide (ITO), or any allow thereof.

A buffer layer BFL may be disposed over the lower conductive layer BML and the first power conductive layer PL2a. The buffer layer BFL may prevent an impurity from being diffused into each circuit element. The buffer layer BFL may be configured as a single layer, but be configured as a multi-layer including at least two layers. In case that the buffer layer BFL is provided as the multi-layer, the layers may be formed of a same material or be formed of different materials.

A semiconductor pattern SCP may be disposed on the buffer layer BFL. In an example, the semiconductor pattern SCP may include a first region contacting a first transistor electrode TE1, a second region contacting a second transistor electrode TE2, and a channel region located between the first and second regions. In some embodiments, one of the first and second regions may be a source region, and the other of the first and second regions may be a drain region.

In some embodiments, the semiconductor pattern SCP may be made of polysilicon, amorphous silicon, oxide semiconductor, etc. In addition, the channel region of the semiconductor pattern SCP is a semiconductor pattern undoped with an impurity and may be an intrinsic semiconductor. Each of the first and second regions of the semiconductor pattern SCP may be a semiconductor pattern doped with an impurity.

A gate insulating layer GI may be disposed on the buffer layer BFL and the semiconductor pattern SCP. In an example, the gate insulating layer GI may be disposed between the semiconductor pattern SCP and a gate electrode GE. Also, the gate insulating layer GI may be disposed between the buffer layer BFL and a second power conductive layer PL2b. The gate insulating layer GI may be configured as a single layer or a multi-layer, and include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The gate electrode GE of the transistor M and the second power conductive layer PL2b may be disposed on the gate insulating layer GI. For example, the gate electrode GE and the second power conductive layer PL2b may be disposed in a same layer. For example, the gate electrode GE and the second power conductive layer PL2b may be simultaneously formed by a same process, but embodiments of the disclosure are not limited thereto. The gate electrode GE may be disposed on the gate insulating layer GI to overlap the semiconductor pattern SCP in the third direction (e.g., Z-axis direction). The second power conductive layer PL2b may be disposed on the gate insulating layer GI to overlap the first power conductive layer PL2a in the third direction (e.g., Z-axis direction). The second power conductive layer PL2b along with the first power conductive layer PL2a may form the second power line PL2 described with reference to FIG. 4 and the like.

The gate electrode GE and the second power conductive layer PL2b may be formed as a single layer or a multi-layer, which is made of at least one of titanium (Ti), copper (Cu), indium tin oxide (ITO), molybdenum (Mo), chromium (Cr), gold (Au), nickel (Ni), and neodymium (Nd), or any alloy thereof. For example, each of the gate electrode GE and the second power conductive layer PL2b may be formed as a multi-layer in which titanium (Ti), copper (Cu), and/or indium tin oxide (ITO) are sequentially or repeatedly stacked.

An interlayer insulating layer ILD may be disposed over the gate electrode GE and the second power conductive layer PL2b. In an example, the interlayer insulating layer ILD may be disposed between the gate electrode GE and the first and second transistor electrodes TE1 and TE2. Also, the interlayer insulating layer ILD may be disposed between the second power conductive layer PL2b and a third power conductive layer PL2c.

The interlayer insulating layer ILD may be configured as a single layer or a multi-layer, and include various kinds of inorganic insulating materials, including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The first and second transistor electrodes TE1 and TE2 and the third power conductive layer PL2c may be disposed on the interlayer insulating layer ILD. The first and second transistor electrodes TE1 and TE2 and the third power conductive layer PL2c may be disposed in a same layer. For example, both the first and second transistor electrodes TE1 and TE2 and the third power conductive layer PL2c may be formed by a same process, but embodiments of the disclosure are not limited thereto.

The first and second transistor electrodes TE1 and TE2 may be disposed to overlap the semiconductor pattern SCP in the third direction (e.g., Z-axis direction). The first and second transistor electrodes TE1 and TE2 may be electrically connected to the semiconductor pattern SCP. For example, the first transistor electrode TE1 may be electrically connected to the first region of the semiconductor pattern SCP through a contact hole penetrating the interlayer insulating layer ILD. The second transistor electrode TE2 may be electrically connected to the second region of the semiconductor pattern SCP through a contact hole penetrating the interlayer insulating layer ILD. Also, the second transistor electrode TE2 may be electrically connected to the lower conductive layer BML through a contact hole penetrating the interlayer insulating layer ILD and the buffer layer BFL. In some embodiments, one of the first and second transistor electrodes TE1 and TE2 may be a source electrode, and the other of the first and second transistor electrodes TE1 and TE2 may be a drain electrode.

The third power conductive layer PLC2c may be disposed to overlap the first power conductive layer PL2a and/or the second power conductive layer PL2b in the third direction (e.g., Z-axis direction). The third power conductive layer PL2c may be electrically connected to the first power conductive layer PL2a and/or the second power conductive layer PL2b. For example, the third power conductive layer PL2c may be electrically connected to the first power conductive layer PL2a through a contact hole penetrating the interlayer insulating layer ILD and the buffer layer BFL. Also, the third power conductive layer PL2c may be electrically connected to the second power conductive layer PL2b through a contact hole penetrating the interlayer insulating layer ILD. The third power conductive layer PL2c along with the first power conductive layer PL2a and/or the second power conductive layer PL2b may form the second power line PL2 described with reference to FIG. 4 and the like.

The first and second transistor electrodes TE1 and TE2 and the third power conductive layer PL2c may be formed as a single layer or a multi-layer, which is made of at least one of aluminum (Al), molybdenum (Mo), chromium (Cr), gold (Au), titanium (Ti), nickel (Ni), neodymium (Nd), and indium tin oxide (ITO), or any alloy thereof.

A protective layer PSV may be disposed over the first and second transistor electrodes TE1 and TE2 and the third power conductive layer PL2c. The protective layer PSV may be formed as a single layer or a multi-layer, and include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

A via layer VIA may be disposed on the protective layer PSV. The via layer VIA may be made of an organic material to planarize a lower step difference (or height or thickness difference). For example, the via layer VIA may include an organic material such as acrylic resin, epoxy resin, phenolic resin, polyamides resin, polyimides resin, unsaturated polyesters resin, poly-phenylene ethers resin, poly-phenylene sulfides resin, or benzocyclobutene (BCB). However, embodiments of the disclosure are not limited thereto, and the via layer VIA may include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

Bank patterns BNP may be disposed on the via layer VIA. In some embodiments, the bank patterns BNP may have various shapes. In an embodiment, the bank patterns BNP may protrude in the third direction (e.g., Z-axis direction) on the substrate SUB. Also, the bank patterns BNP may have an inclined surface inclined at an angle (e.g., a predetermined or selected angle) with respect to the substrate SUB. However, embodiments of the disclosure are not limited thereto, and the bank patterns BNP may have a sidewall having a curved shape, a stepped shape, or the like. In an example, the bank patterns BNP may have a section having a semicircular shape, a semi-elliptical shape, or the like.

Electrodes and insulating layers, which are disposed on the top of the bank patterns BNP, may have a shape corresponding to that of the bank patterns BNP. In an example, electrodes ALE disposed on the bank patterns BNP may include an inclined surface or a curved surface, which has a shape corresponding to that of the bank patterns BNP. Accordingly, the bank patterns BNP along with the electrodes ALE provided on the top thereof may serve as a reflective member for guiding light emitted from light emitting elements LD in a front direction of the pixel PXL, for example, the third direction (e.g., Z-axis direction), thereby improving the light emission efficiency of the display panel PNL.

The bank patterns BNP may include at least one organic material and/or at least one inorganic material. In an example, the bank patterns BNP may include an organic material such as acrylic resin, epoxy resin, phenolic resin, polyamides resin, polyimides resin, unsaturated polyesters resin, poly-phenylene ethers resin, poly-phenylene sulfides resin, or benzocyclobutene (BCB). However, embodiments of the disclosure are not limited thereto, and the bank patterns BNP may include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The electrodes ALE may be disposed on the via layer VIA and the bank patterns BNP. The electrodes ALE may be disposed in the pixel PXL to be spaced apart from each other. The electrodes ALE may be disposed in a same layer. The electrodes ALE may be simultaneously formed by a same process, but embodiments of the disclosure are not limited thereto.

The electrodes ALE may be supplied with an alignment signal in a process of aligning the light emitting elements LD. Accordingly, an electric filed is formed between the electrodes ALE, so that the light emitting elements LD provided in each pixel PXL can be aligned between the electrodes ALE.

The electrodes ALE may include at least one conductive material. In an example, the electrodes ALE may include at least one metal among silver (Ag), magnesium (Mg), aluminum (Al), platinum (Pt), palladium (Pd), gold (Au), nickel (Ni), neodymium (Nd), iridium (Ir), chromium (Cr), titanium (Ti), molybdenum (Mo), and copper (Cu), and the like or an alloy including the at least one metal, at least one conductive oxide such as indium tin oxide (ITO), indium zinc oxide (IZO), indium tin zinc oxide (ITZO), aluminum doped zinc oxide (AZO), gallium doped zinc oxide (GZO), zinc tin oxide (ZTO), or gallium tin oxide (GTO), and at least one conductive material such as PEDOT, but embodiments of the disclosure are not limited thereto.

A first electrode ALE1 may be electrically connected to the first transistor electrode TE1 of the transistor M through a contact hole penetrating the via layer VIA and the protective layer PSV. A third electrode ALE3 may be electrically connected to the third power conductive layer PL2c through a contact hole penetrating the via layer VIA and the protective layer PSV.

A first insulating layer INS1 may be disposed over the electrodes ALE. The first insulating layer INS1 may be configured as a single layer or a multi-layer, and include various kinds of inorganic insulating materials, including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

A bank BNK may be disposed on the first insulating layer INS1. The bank BNK may form a dam structure defining an emission area in which light emitting elements LD are to be supplied in a process of supplying the light emitting elements LD to each of the pixels PXL. For example, a desired kind and/or amount of light emitting element ink may be supplied to the area defined by the bank BNK.

The bank BNK may include an organic material such as acrylic resin, epoxy resin, phenolic resin, polyamides resin, polyimides resin, unsaturated polyesters resin, poly-phenylene ethers resin, poly-phenylene sulfides resin, or benzocyclobutene (BCB). However, embodiments of the disclosure are not limited thereto, and the bank BNK may include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

In some embodiments, the bank BNK may include at least one light blocking material and/or at least one reflective material. Accordingly, light leakage between adjacent pixels PXL can be prevented. For example, the bank BNK may include at least one black matrix material and/or at least one color filter material. In an example, the bank BNK may be formed as a black opaque pattern capable of blocking transmission of light. In an embodiment, a reflective layer or the like may be formed on a surface (e.g., a sidewall) of the bank BNK to increase the light efficiency of each pixel PXL.

The light emitting elements LD may be disposed on the first insulating layer INS1. The light emitting elements LD may be disposed between the electrodes ALE on the first insulating layer INS1. The light emitting elements LD may be prepared in a form in which the light emitting elements LD are dispersed in a light emitting element ink, to be supplied to each of the pixels PXL by an inkjet printing process, or the like. In an example, the light emitting elements LD may be dispersed in a volatile solvent and may be provided to each pixel PXL. Subsequently, in case that an alignment signal is supplied through the electrodes ALE, the light emitting elements LD may be aligned between the electrodes ALE, while an electric field is formed between the electrodes ALE. After the light emitting elements LD are aligned, the solvent may be volatilized or removed through other processes, so that the light emitting elements LD can be stably arranged between the electrodes ALE.

The conductive patterns CP may be disposed on the first insulating layer INS. In an example, the conductive patterns CP may be disposed between the electrodes ALE on the first insulating layer INS1. In an embodiment, a length L2 of the conductive patterns CP in the first direction (e.g., X-axis direction) may be greater than or equal to a length L1 of the light emitting elements LD in the first direction (e.g., X-axis direction). In an example, the length L2 of the conductive patterns CP in the first direction (e.g., X-axis direction) may be about 4.0 µm or more. As another example, the length L2 of the conductive patterns CP in the first direction (e.g., X-axis direction) may be about 6.1 µm or more so as to effectively reduce an open defect. However, embodiments of the disclosure are not limited thereto, and the length L2 of the conductive patterns CP in the first direction (e.g., X-axis direction) may be variously changed in consideration of a process margin, etc.

A second insulating layer INS2 may be disposed on the light emitting elements LD and the conductive patterns CP. For example, the second insulating layer INS2 may be partially provided on the light emitting elements LD and expose first and second end portions EP1 and EP2 of the light emitting elements LD. In case that the second insulating layer INS2 is formed on the light emitting elements LD after the alignment of the light emitting elements LD is completed, the light emitting elements LD can be prevented from being separated from a position at which the light emitting elements LD are aligned.

Also, the second insulating layer INS2 may be partially provided on the conductive patterns CP and expose first and second end portions EPa and EPb of the conductive patterns CP. As described above, the second insulating layer INS2 is formed on the light emitting elements LD and the conductive patterns CP, so that the connection electrodes ELT which will be described below can be stably separated from each other.

The second insulating layer INS2 may be configured as a single layer or a multi-layer, and include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The connection electrodes ELT may be disposed on the first and second end portions EP1 and EP2 of the light emitting elements LD, which are exposed by the second insulating layer INS2. A first electrode ELT1 may be directly disposed on first end portions EP1 of first light emitting elements LD1 to contact the first end portions EP1 of the first light emitting elements LD1.

In addition, a second connection electrode ELT2 may be directly disposed on second end portions EP2 of the first light emitting elements LD1 to contact the second end portions EP2 of the first light emitting elements LD1. Also, the second connection electrode ELT2 may be directly disposed on first end portions EP1 of second light emitting elements LD2 to contact the first end portions EP1 of the second light emitting elements LD2. For example, the second connection electrode ELT2 may electrically connect the second end portions EP2 of the first light emitting elements LD1 and the first end portions EP1 of the second light emitting elements LD2 to each other.

Similarly, a third connection electrode ELT3 may be directly disposed on second end portions EP2 of the second light emitting elements LD2 to contact the second end portions EP2 of the second light emitting elements LD2. Also, the third connection electrode ELT3 may be directly disposed on first end portions EP1 of third light emitting elements LD3 to contact the first end portions EP1 of the third light emitting elements LD3. For example, the third connection electrode ELT3 may electrically connect the second end portions EP2 of the second light emitting elements LD2 and the first end portions EP1 of the third light emitting elements LD3 to each other.

Similarly, a fourth connection electrode ELT4 may be directly disposed on second end portions EP2 of the third light emitting elements LD3 to contact the second end portions EP2 of the third light emitting elements LD3. Also, the fourth connection electrode ELT4 may be directly disposed on first end portions EP1 of fourth light emitting elements LD4 to contact the first end portions EP1 of the fourth light emitting elements LD4. For example, the fourth connection electrode ELT4 may electrically connect the second end portions EP2 of the third light emitting elements LD3 and the first end portions EP1 of the fourth light emitting elements LD4 to each other.

Similarly, a fifth connection electrode ELT5 may be directly disposed on second end portions EP2 of the fourth light emitting elements LD4 to contact the second end portions EP2 of the fourth light emitting elements LD4.

In addition, the connection electrodes ELT may be disposed on the first and second end portions EPa and EPb of the conductive patterns CP, which are exposed by the second insulating layer INS2. The first connection electrode ELT1 may be directly disposed on a first end portion EPa of a first conductive pattern CP1 to contact the first end portion EPa of the first conductive pattern CP1.

In addition, the second connection electrode ELT2 may be directly disposed on a second end portion EPb of the first conductive pattern CP1 to contact the second end portion EPb of the first conductive pattern CP1. Also, the second connection electrode ELT2 may be directly disposed on a first end portion EPa of a second conductive pattern CP2 to contact the first end portion EPa of the second conductive pattern CP2.

Similarly, the third connection electrode ELT3 may be directly disposed on a second end portion EPb of the second conductive pattern CP2 to contact the second end portion EPb of the second conductive pattern CP2. Also, the third connection electrode ELT3 may be directly disposed on a first end portion EPa of a third conductive pattern CP3 to contact the first end portion EPa of the third conductive pattern CP3.

Similarly, the fourth connection electrode ELT4 may be directly disposed on a second end portion EPb of the third conductive pattern CP3 to contact the second end portion EPb of the third conductive pattern CP3. Also, the fourth connection electrode ELT4 may be directly disposed on a first end portion EPa of a fourth conductive pattern CP4 to contact the first end portion EPa of the fourth conductive pattern CP4.

Similarly, the fifth connection electrode ELT5 may be directly disposed on a second end portion EPb of the fourth conductive pattern CP4 to contact the second end portion EPb of the fourth conductive pattern CP4.

As described above, in case that the first to fifth connection electrodes ELT1, ELT2, ELT3, ELT4, and ELT5 contact the high-resistance first to fourth conductive patterns CP1, CP2, CP3, and CP4, a current flows even in case that an open defect occurs in some serial stages. For example, a luminance (e.g., a predetermined or selected luminance) can be expressed by light emitting elements LD of the other serial stages. Thus, a dark spot defect of the pixel PXL can be reduced, which has been described above.

In an embodiment, some of the connection electrodes ELT may be disposed in a same layer. For example, the first connection electrode ELT1, the third connection electrode ELT3, and the fifth connection electrode ELT5 may be disposed in a same layer. In addition, the second connection electrode ELT2 and the fourth connection electrode ELT4 may be disposed in a same layer. In an example, the first connection electrode ELT1, the third connection electrode ELT3, and the fifth connection electrode ELT5 may be disposed on the second insulating layer INS2. A third insulating layer INS3 may be disposed on the first connection electrode ELT1, the third connection electrode ELT3, and the fifth connection electrode ELT5. The second connection electrode ELT2 and the fourth connection electrode ELT4 may be disposed on the third insulating layer INS3.

The third insulating layer INS3 may expose the second end portions EP2 of the light emitting elements LD. The connection electrodes ELT may be formed on the second end portions EP2 of the light emitting elements LD, which are exposed by the third insulating layer INS3. Also, the third insulating layer INS3 may expose the second end portions EPb of the conductive patterns CP. The connection electrodes ELT may contact the second end portions EPb of the conductive patterns CP, which are exposed by the third insulating layer INS3.

As described above, in case that the third insulating layer INS3 is disposed between the connection electrodes ELT configured as different conductive layers, the connection electrodes ELT can be stably separated from each other by the third insulating layer INS3, and thus the electrical stability between the first and second end portions EP1 and EP2 of the light emitting elements LD can be ensured.

The connection electrodes ELT may be made of various transparent conductive materials. In an example, the connection electrodes ELT may include at least one of various transparent conductive materials including indium tin oxide (ITO), indium zinc oxide (IZO), indium tin zinc oxide (ITZO), aluminum doped zinc oxide (AZO), gallium doped zinc oxide (GZO), zinc tin oxide (ZTO), and gallium tin oxide (GTO), and may be implemented substantially transparently or translucently to satisfy a predetermined transmittance. Accordingly, light emitted from the first and second end portions EP1 and EP2 of the light emitting elements LD can be emitted to the outside of the display panel PNL while passing through the connection electrodes ELT.

The third insulating layer INS3 may be configured as a single layer or a multi-layer and include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

In accordance with the embodiment described above, the high-resistance conductive patterns CP are formed between the connection electrodes ELT, so that a current can flow even in case that an open defect occurs in some serial stages. Accordingly, a luminance can be expressed by light emitting elements LD of the other serial stages, and thus a dark spot defect of the pixel PXL can be reduced.

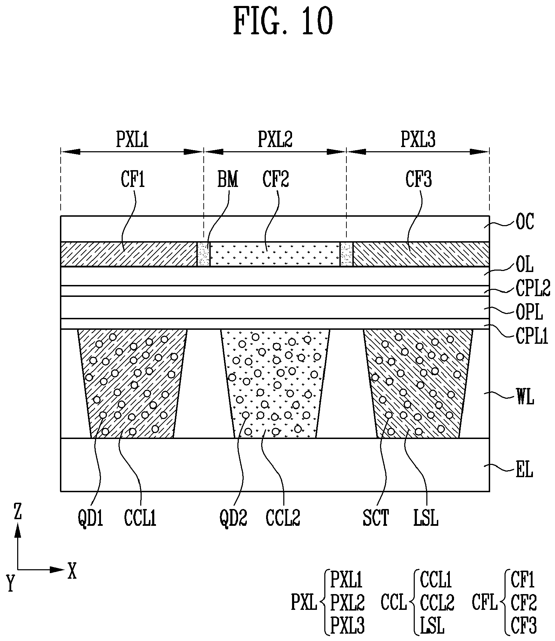

FIG. 10 is a schematic cross-sectional view illustrating first to third pixels in accordance with an embodiment.

FIG. 10 illustrates a partition wall WL, a color conversion layer CCL, and/or a color filter layer CFL, which are provided on the light emitting element layer EL of the pixel PXL described with reference to FIGS. 5 to 9.

Referring to FIG. 10, the partition wall WL may be disposed on the light emitting element layer EL of the first to third pixels PXL1, PXL2, and PXL3. In an example, the partition wall WL may be disposed between the first to third pixels PXL1, PXL2, and PXL3 or at a boundary between the first to third pixels PXL1, PXL2, and PXL3 and may include an opening overlapping each of the first to third pixels PXL1, PXL2, and PXL3. The opening of the partition wall WL may provide a space in which the color conversion layer CCL can be provided.

The partition wall WL may include an organic material such as acrylic resin, epoxy resin, phenolic resin, polyamides resin, polyimides resin, unsaturated polyesters resin, poly-phenylene ethers resin, poly-phenylene sulfides resin, or benzocyclobutene (BCB). However, embodiments of the disclosure are not limited thereto, and the partition wall WL may include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

In some embodiments, the partition wall WL may include at least one light blocking material and/or at least one reflective material. Accordingly, light leakage between adjacent pixels PXL can be prevented. For example, the partition wall WL may include at least one black matrix material and/or at least one color filter material. In an example, the partition wall WL may be formed as a black opaque pattern capable of blocking transmission of light. In an embodiment, a reflective layer (not shown) or the like may be formed on a surface (e.g., a sidewall) of the partition wall WL so as to improve the light efficiency of each pixel PXL.

The color conversion layer CCL may be disposed on the light emitting element layer EL including the light emitting elements LD in the opening of the partition wall WL. The color conversion layer CCL may include a first color conversion layer CCL1 disposed in the first pixel PXL1, a second color conversion layer CCL2 disposed in the second pixel PXL2, and a light scattering layer LSL disposed in the third pixel PXL3.

In an embodiment, the first to third pixels PXL1, PXL2, and PXL3 may include light emitting elements LD emitting light of a same color. For example, the first to third pixels PXL1, PXL2, and PXL3 may include light emitting elements LD emitting light of a third color (or blue). The color conversion layer CCL including color conversion particles is disposed on each of the first to third pixels PXL1, PXL2, and PXL3, so that a full-color image can be displayed.

The first color conversion layer CCL1 may include first color conversion particles for converting light of the third color, which is emitted from the light emitting element LD, into light of a first color. For example, the first color conversion layer CCL1 may include first quantum dots QD1 dispersed in a predetermined matrix material such as base resin.

In an embodiment, in case that the light emitting element LD is a blue light emitting element emitting light of blue, and the first pixel PXL1 is a red pixel, the first color conversion layer CCL1 may include a first quantum dot QD1 for converting light of blue, which is emitted from the blue light emitting element, into light of red. The first quantum dot QD1 may absorb blue light and emit red light by shifting a wavelength of the blue light according to energy transition. In case that the first pixel PXL1 is a pixel of another color, the first color conversion layer CCL1 may include a first quantum dot QD1 corresponding to the color of the first pixel PXL1.

The second color conversion layer CCL2 may include second color conversion particles for converting light of the third color, which is emitted from the light emitting element LD, into light of a second color. For example, the second color conversion layer CCL2 may include second quantum dots QD2 dispersed in a matrix material such as base resin.

In an embodiment, in case that the light emitting element LD is a blue light emitting element emitting light of blue, and the second pixel PXL2 is a green pixel, the second color conversion layer CCL2 may include a second quantum dot QD2 for converting light of blue, which is emitted from the blue light emitting element, into light of green. The second quantum dot QD2 may absorb blue light and emit green light by shifting a wavelength of the blue light according to energy transition. In case that the second pixel PXL2 is a pixel of another color, the second color conversion layer CCL2 may include a second quantum dot QD2 corresponding to the color of the second pixel PXL2.

In an embodiment, light of blue having a relatively short wavelength in a visible light band is incident onto the first quantum dot QD1 and the second quantum dot QD2, so that absorption coefficients of the first quantum dot QD1 and the second quantum dot QD2 can be increased. Accordingly, the efficiency of light finally emitted from the first pixel PXL1 and the second pixel PXL2 can be improved, and excellent color reproduction can be ensured. In addition, the light emitting part EMU of each of the first to third pixels PXL1, PXL2, and PXL3 is configured using light emitting elements of a same color (e.g., blue light emitting elements), so that the manufacturing efficiency of the display device can be improved.

The light scattering layer LSL may be provided to efficiently use light of the third color (or blue) emitted from the light emitting element LD. In an example, in case that the light emitting element LD is a blue light emitting element emitting light of blue, and the third pixel PXL3 is a blue pixel, the light scattering layer LSL may include at least one kind of light scattering particles SCT to efficiently use light emitted from the light emitting element LD.

For example, the light scattering layer LSL may include light scattering particles SCT dispersed in a matrix material such as base resin. In an example, the light scattering layer LSL may include a light scattering particle SCT such as silica, but the material forming the light scattering particles SCT of embodiments is not limited thereto. The light scattering particles SCT are not disposed in only the third pixel PXL3 and may be selectively included even inside the first color conversion layer CCL1 or the second color conversion layer CCL2. In some embodiments, the light scattering particle SCT may be omitted such that the light scattering layer LSL configured with transparent polymer is provided.

A first capping layer CPL1 may be disposed on the color conversion layer CCL. The first capping layer CPL1 may be provided over the first to third pixels PXL1, PXL2, and PXL3. The first capping layer CPL1 may cover the color conversion layer CCL. The first capping layer CPL1 may prevent the color conversion layer CCL from being damaged or contaminated due to infiltration of an impurity such as moisture or air from the outside.

The first capping layer CPL1 is an inorganic layer and may include silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), silicon oxynitride (SiOₓN_{y}), and the like.

An optical layer OPL may be disposed on the first capping layer CPL1. The optical layer OPL may be provided over the first to third pixels PXL1, PXL2, and PXL3.

The optical layer OPL may function to improve light extraction efficiency by recycling light provided from the color conversion layer CCL by total reflection. To this end, the optical layer OPL may have a refractive index relatively lower than that of the color conversion layer CCL. For example, the refractive index of the color conversion layer may be about 1.6 to about 2.0, and the refractive index of the optical layer OPL may be about 1.1 to about 1.3. However, embodiments of the disclosure are not limited thereto.

In some embodiments, the optical layer OPL may include a base resin and hollow particles dispersed in the base resin. The hollow particle may include a hollow silica particle. As another example, the hollow particle may be a pore formed by porogen, but embodiments of the disclosure are not limited thereto. Also, the optical layer OPL may include at least one of a titanium dioxide (TiO₂) particle and a nanosilicate particle, but embodiments of the disclosure are not limited thereto.

A second capping layer CPL2 may be disposed on the optical layer OPL. The second capping layer CPL2 may be provided over the first to third pixels PXL1, PXL2, and PXL3. The second capping layer CPL2 may cover the optical layer OPL. The second capping layer CPL2 may prevent the optical layer OPL from being damaged or contaminated due to infiltration of an impurity such as moisture or air from the outside.

The second capping layer CPL2 is an inorganic layer and may include silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), silicon oxynitride (SiOₓN_{y}), and the like.

A planarization layer OL may be disposed on the second capping layer CPL2. The planarization layer OL may be provided over the first to third pixels PXL1, PXL2, and PXL3.

The planarization layer OL may include an organic material such as acrylic resin, epoxy resin, phenolic resin, polyamides resin, polyimides resin, unsaturated polyesters resin, poly-phenylene ethers resin, poly-phenylene sulfides resin, or benzocyclobutene (BCB). However, embodiments of the disclosure are not limited thereto, and the planarization layer OL may include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The color filter layer CFL may be disposed on the planarization layer OL. The color filter layer CFL may include color filters CF1, CF2, and CF3 which accord with a color of respective pixel PXL. The color filters CF1, CF2, and CF3 which respectively accord with colors of the first to third pixels PXL1, PXL2, and PXL3 are disposed, so that a full-color image can be displayed.

The color filter layer CFL may include a first color filter CF1 disposed in the first pixel PXL1 to allow light emitted from the first pixel PXL1 to be selectively transmitted therethrough, a second color filter CF2 disposed in the second pixel PXL2 to allow light emitted from the second pixel PXL2 to be selectively transmitted therethrough, and a third color filter CF3 disposed in the third pixel PXL3 to allow light emitted from the third pixel PXL3 to be selectively transmitted therethrough.

In an embodiment, the first color filter CF1, the second color filter CF2, and the third color filter CF3 may be respectively a red color filter, a green color filter, and a blue color filter, but embodiments of the disclosure are not limited thereto. Hereinafter, in case that an arbitrary color filter among the first color filter CF1, the second color filter CF2, and the third color filter CF3 is designated or in case that two or more kinds of color filters are inclusively designated, the corresponding color filter or the corresponding color filters are referred to as a "color filter CF" or "color filters CF."

The first color filter CF1 may overlap the light emitting element layer EL (or the light emitting element LD) and the first color conversion layer CCL of the first pixel PXL1 in the third direction (e.g., Z-axis direction). The first color filter CF1 may include a color filter material for allowing light of a first color (or red) to be selectively transmitted therethrough. For example, in case that the first pixel PXL1 is a red pixel, the first color filter CF1 may include a red color filter material.

The second color filter CF2 may overlap the light emitting element layer EL (or the light emitting element LD) and the second color conversion layer CCL2 of the second pixel PXL2 in the third direction (e.g., Z-axis direction). The second color filter CF2 may include a color filter material for allowing light of a second color (or green) to be selectively transmitted therethrough. For example, in case that the second pixel PXL2 is a green pixel, the second color filter CF2 may include a green color filter material.

The third color filter CF3 may overlap the light emitting element layer EL (or the light emitting element LD) and the light scattering layer LSL of the third pixel PXL3 in the third direction (e.g., Z-axis direction). The third color filter CF3 may include a color filter material for allowing light of a third color (or blue) to be selectively transmitted therethrough. For example, in case that the third pixel PXL3 is a blue pixel, the third color filter CF3 may include a blue color filter material.

In some embodiments, a light blocking layer BM may be further disposed between the first to third color filters CF1, CF2, and CF3 or at a boundary between the first to third color filters CF1, CF2, and CF3. As described above, in case that the light blocking layer BM is formed between the first to third color filters CF1, CF2, and CF3, a color mixture defect viewed at the front or side of the display device can be prevented. The material of the light blocking layer BM is not particularly limited, and the light blocking layer BM may be configured with various light blocking materials. In an example, the light blocking layer BM may be implemented by stacking the first to third color filters CF1, CF2, and CF3.

An overcoat layer OC may be disposed on the color filter layer CFL. The overcoat layer OC may be provided over the first to third pixels PXL1, PXL2, and PXL3. The overcoat layer OC may cover (or overlap in a plan view) a lower member including the color filter layer CFL. The overcoat layer OC may prevent moisture or air from infiltrating into the above-described lower member. Also, the overcoat layer OC may protect the above-described lower member from a foreign matter such as dust.

The overcoat layer OC may include an organic material such as acrylic resin, epoxy resin, phenolic resin, polyamides resin, polyimides resin, unsaturated polyesters resin, poly-phenylene ethers resin, poly-phenylene sulfides resin, or benzocyclobutene (BCB). However, embodiments of the disclosure are not limited thereto, and the overcoat layer OC may include various kinds of inorganic insulating materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

As discussed, embodiments of the invention provide a display device comprising: a first electrode and a second electrode, spaced apart from each other; light emitting elements disposed between the first electrode and the second electrode; a first connection electrode electrically contacting the first electrode and first end portions of the light emitting elements; a second connection electrode electrically contacting the second electrode and second end portions of the light emitting elements; and a conductive pattern disposed between the first connection electrode and the second connection electrode, wherein a first end portion of the conductive pattern electrically contacts the first connection electrode, and a second end portion of the conductive pattern electrically contacts the second connection electrode.

The first and second electrodes may be alignment electrodes.

In some embodiments, in each pixel a plurality of the light emitting elements and the conductive pattern are connected between the first and second connection electrodes.

The conductive pattern may be higher resistance than the light emitting elements.

Each pixel may comprise light emitting elements electrically connected between the first connection electrode and the second connection electrode, and second light emitting elements electrically connected between the second connection electrode and a third connection electrode.

In some embodiments, the second connection electrode electrically contacts first end portions of the second light emitting elements and the third connection electrode electrically contacts second end portions of the second light emitting elements. In some embodiments, a second conductive pattern is provided that electrically contacts the second connection electrode and the third connection electrode. The second conductive pattern may be higher resistance than the second light emitting elements.

Embodiments of the invention can provide a display device comprising: first light emitting elements and second light emitting elements, disposed in each pixel; a first connection electrode electrically contacting first end portions of the first light emitting elements; a second connection electrode electrically contacting second end portions of the first light emitting elements and first end portions of the second light emitting elements; a third connection electrode electrically contacting second end portions of the second light emitting elements; a first conductive pattern electrically contacting the first connection electrode and the second connection electrode; and a second conductive pattern electrically contacting the second connection electrode and the third connection electrode.

The first and second conductive patterns may be higher resistance than the light emitting elements.

In accordance with the disclosure, although an open defect occurs in some serial stages, a current flows by forming high-resistance conductive patterns between connection electrodes, so that a luminance (e.g., a predetermined or selected luminance) can be expressed by light emitting elements of the other serial stages. Thus, a dark spot defect of a pixel can be reduced.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the disclosure.

## Claims

1. A display device comprising:
a first electrode and a second electrode, spaced apart from each other;
light emitting elements disposed between the first electrode and the second electrode;
a first connection electrode electrically contacting the first electrode and first end portions of the light emitting elements;
a second connection electrode electrically contacting the second electrode and second end portions of the light emitting elements; and
a conductive pattern disposed between the first connection electrode and the second connection electrode, wherein
a first end portion of the conductive pattern electrically contacts the first connection electrode, and
a second end portion of the conductive pattern electrically contacts the second connection electrode.

2. The display device of claim 1, wherein a length of the conductive pattern is greater than or equal to lengths of the light emitting elements.

3. The display device of claims 1 or 2, wherein the conductive pattern has a resistance higher than resistances of the light emitting elements.

4. The display device of any one of claims 1 to 3, wherein the conductive pattern has a resistance of about 100 kΩ or more.

5. The display device of any one of claims 1 to 4, further comprising:
a first insulating layer disposed over the first electrode and the second electrode; and
a second insulating layer disposed on the light emitting elements,
wherein the second insulating layer exposes the first and second end portions of the light emitting elements.

6. The display device of claim 5, wherein the conductive pattern is disposed between the first insulating layer and the second insulating layer.

7. The display device of claim 6, wherein the second insulating layer exposes the first and second end portions of the conductive pattern;
optionally wherein the first connection electrode electrically contacts the first end portion of the conductive pattern which is exposed by the second insulating layer;
optionally further comprising a third insulating layer disposed on the first connection electrode, wherein the third insulating layer exposes the second end portion of the conductive pattern;
optionally wherein the second connection electrode electrically contacts the second end portion of the conductive pattern which is exposed by the third insulating layer.

8. A display device comprising:
first light emitting elements and second light emitting elements, disposed in each pixel;
a first connection electrode electrically contacting first end portions of the first light emitting elements;
a second connection electrode electrically contacting second end portions of the first light emitting elements and first end portions of the second light emitting elements;
a third connection electrode electrically contacting second end portions of the second light emitting elements;
a first conductive pattern electrically contacting the first connection electrode and the second connection electrode; and
a second conductive pattern electrically contacting the second connection electrode and the third connection electrode.

9. The display device of claim 8, wherein the first light emitting elements and the second light emitting elements are electrically connected in series to each other.

10. The display device of claim 8 or 9, wherein the first conductive pattern and the second conductive pattern include a same material.

11. The display device of any one of claims 8 to 10, wherein the first connection electrode and the third connection electrode are disposed on a same layer.

12. The display device of any one of claims 8 to 11, further comprising:
third light emitting elements and fourth light emitting elements, disposed in the pixel;
a fourth connection electrode electrically contacting second end portions of the third light emitting elements and first end portions of the fourth light emitting elements; and
a fifth connection electrode electrically contacting second end portions of the fourth light emitting elements.

13. The display device of claim 12, further comprising:
a third conductive pattern electrically contacting the third connection electrode and the fourth connection electrode; and/or
a fourth conductive pattern electrically contacting the fourth connection electrode and the fifth connection electrode.

14. The display device of claim 12 or 13, wherein the first to fourth light emitting elements are electrically connected in series to each other.

15. The display device of any one of claims 12 to 14, wherein the second connection electrode and the fourth connection electrode are disposed on a same layer; and/or
wherein the fifth connection electrode, the first connection electrode, and the third connection electrode are disposed on a same layer.
